# DEMANDE DE BREVET EUROPEEN

(11) **EP 0 916 748 A1**
(43) Date de publication de la demande: **19.05.1999**
(21) Numéro de dépôt: 98402833.2
(22) Date de dépôt: 16.11.1998
(51) Int. Cl.: C30B 19/02, C30B 29/20, H01S 3/113

(54) **Couches monocristallines d'aluminate de lanthane et de magnésium (LMA), leur proédé de préparation par croissance par épitaxie en phase liquide et composants optiques comprenant ces couches**

(30) Priorité: 18.11.1997 FR 9714434
(71) Demandeur: COMMISSARIAT A L'ENERGIE ATOMIQUE, 75015 Paris (FR)
(72) Inventeur: Ferrand, Bernard, 38340 Voreppe (FR); Chambaz, Bernard, 38180 Seyssins (FR); Basset, Gérard, 38520 Bourg d'Oisans (FR); Calvat, Claude, 26760 Monteleger (FR)
(74) Mandataire: Dubois-Chabert, Guy

(57) **Abrégé**

L'invention concerne des couches monocristallines d'aluminate de lanthane et de magnésium (LaMgAl₁₁O₁₉) (LMA), éventuellement dopées, et leur procédé de préparation, sur un substrat, par croissance par épitaxie en phase liquide à partir d'un bain d'épitaxie comprenant un solvant et un soluté, dans lequel ledit solvant est constitué d'un mélange de Bi₂O₃ et de B₂O₃, et la croissance épitaxiale est réalisée à température constante dans la gamme de 900 à 1100 °C.

De tels matériaux présentent les propriétés optiques adéquates pour réaliser des composants optiques, tels que sources lasers, absorbants saturables, amplificateurs en particulier dans les dispositifs de types microlasers pompés par des diodes.

## Description

L'invention concerne des couches monocristallines d'aluminate de lanthane et de magnésium (LMA), l'invention concerne également un procédé de préparation par croissance par épitaxie en phase liquide de couches monocristallines, en particulier de couches minces, d'un matériau de la famille de l'aluminate de lanthane et de magnésium LaMgAl₁₁O₁₉(LMA), éventuellement dopé.

De tels matériaux présentent les propriétés optiques adéquates pour réaliser des composants optiques, tels que sources lasers, absorbants saturables, amplificateurs, en particulier dans les dispositifs de types microlasers pompés par des diodes.

Le domaine technique de l'invention peut donc être généralement défini comme celui de la mise en forme de matériaux pour dispositifs optiques.

En effet, suivant l'application visée, ces matériaux, qui sont généralement des monocristaux, sont utilisés sous la forme de lames, couches minces, barreaux ou plaques (slabs en anglais) et leurs propriétés et leurs qualités dépendent fortement des procédés de croissance utilisés.

Ainsi, parmi les composants optiques utilisant des monocristaux, il y a, notamment, les amplificateurs. Ces dispositifs sont très utilisés dans le domaine des télécommunications, sous forme de fibres optiques, notamment, et ils se développent aujourd'hui, associés par exemple aux microlasers, pour augmenter leur énergie en vue de nouvelles applications, comme le marquage ou la microdécoupe.

Le processus d'amplification optique par émission stimulée est basé sur l'effet laser. Il nécessite un milieu actif qui peut être rendu amplificateur par pompage afin de satisfaire la condition d'inversion de population.

Le pompage joue donc un rôle très important dans la détermination des performances de l'amplificateur. Deux autres aspects sont également à prendre en compte, en plus de la puissance de la pompe. Il s'agit, d'une part, de la longueur d'onde de pompe, mais aussi de la configuration de pompage. En effet, plusieurs solutions sont possibles : transversalement, longitudinalement ou latéralement.

Dans les applications qui présentent plus particulièrement un intérêt dans le cadre de la présente demande, le pompage est réalisé par des diodes, plus précisément par des barrettes de diodes. D'autre part, il peut être nécessaire d'envisager un refroidissement du matériau à cause des fortes densités d'énergie mises en jeu.

Toutes ces contraintes vont influer sensiblement sur la géométrie de l'amplificateur et donc sur la mise en forme du matériau.

Le choix de la concentration en dopant est également important pour optimiser le processus d'amplification et accroître le gain. En effet, plus il y a d'ions dopants, plus l'énergie de pompe est absorbé et donc plus il sera en principe possible d'amplifier le signal. Toutefois, dans certains cas, une concentration trop élevée en dopant peut nuire au processus par des mécanismes de réabsorption dans l'état excité ou le transfert d'énergie entre ions voisins.

Il apparaît donc que les performances de l'amplificateur vont dépendre fortement des propriétés du matériau, telles que son dopage, son homogénéité, ses défauts et donc du procédé mis en oeuvre pour la préparation de ce matériau.

La plupart des matériaux massifs présentent l'inconvénient qu'il est difficile d'augmenter la concentration en dopants, par exemple du Nd dans Y₃Al₅O₁₂ ou YLiF₄ et donc d'obtenir de forts gains.

Par contre, cette limitation de concentration est repoussée dans certaines couches épitaxiées, notamment celles obtenues par épitaxie en phase liquide (EPL). Un tel procédé de préparation ne peut malheureusement pas, jusqu'à présent, s'appliquer à d'autres matériaux particulièrement intéressants et susceptibles de présenter une forte concentration en dopant, tels que le LaMgAl₁₁O₁₉ (LMA), par exemple dopé au Nd.

D'autres dispositifs optiques mettant en oeuvre les matériaux mentionnés plus haut sont les microlasers, par exemple les microlasers pompés par diodes qui se développent intensément aujourd'hui.

Un des avantages du microlaser réside dans sa structure en un empilement de multicouches. Le milieu actif laser est constitué par un matériau de faible épaisseur par exemple, entre 150-1 000 µm et de petites dimensions (quelques mm²), sur lequel des miroirs diélectriques de cavité sont directement déposés. Ce milieu actif peut être pompé par une diode laser III-V qui est soit directement hybridée sur le microlaser, soit couplée à ce dernier par fibre optique. La possibilité d'une fabrication collective utilisant les moyens de la micro-électronique autorise une production de masse de ces microlasers à très faible coût.

Les microlasers ont de nombreuses applications, dans des domaines aussi variés que l'industrie automobile, l'environnement, l'instrumentation scientifique, la télémétrie, etc...

Les microlasers connus ont, en général, une émission continue de quelques dizaines de mW de puissance. Cependant, la plupart des applications citées ci-dessus, nécessitent des puissances crêtes (puissance instantanée) de quelques kW délivrées pendant 10⁻⁸ à 10⁻⁹ secondes, avec une puissance moyenne de quelques dizaines de mW.

Dans les lasers solides, on peut obtenir de telles puissances crêtes élevées en les faisant fonctionner en mode pulsé à des fréquences variant entre 10 et 10⁴ Hz. Pour cela, on utilise des procédés bien connus de déclenchement, par exemple par « Q-switch ».

De façon plus précise, déclencher une cavité laser consiste à rajouter dans celle-ci des pertes variables dans le temps qui vont empêcher l'effet laser pendant un certain temps, durant lequel l'énergie de pompage est stockée dans le niveau excité du matériau à gain. Ces pertes sont brusquement diminuées, à des moments précis, libérant ainsi l'énergie emmagasinée en un temps très court (pulse géant). On atteint ainsi une puissance crête élevée.

Dans le cas d'un déclenchement dit actif, la valeur des pertes est pilotée de façon externe par l'utilisateur (exemple : miroir de cavité tournant, acousto-optique ou électro-optique intracavité changeant soit le trajet du faisceau, soit son état de polarisation). La durée de stockage, l'instant d'ouverture de la cavité, ainsi que le taux de répétition peuvent être choisis indépendamment. En contrepartie, cela nécessite une électronique adaptée et complique le système laser.

Un microlaser déclenché activement est décrit par exemple dans le document EP-A-724 316.

Dans le cas d'un déclenchement dit passif, les pertes variables sont introduites dans la cavité sous forme d'un matériau (appelé Absorbant Saturable - A. S. -) qui est fortement absorbant (transmission Tmin) à la longueur d'onde laser, à faible densité de puissance, et qui devient pratiquement transparent (transmission Tmax) lorsque cette densité dépasse un certain seuil qu'on appelle intensité de saturation de l'A. S.

L'énorme avantage du déclenchement passif est qu'il ne nécessite aucune électronique de pilotage. Pour ce type de fonctionnement, dit « déclenchement passif », l'utilisateur peut choisir, d'une part, la transmission minimum (Tmin) de l'absorbant saturable, afin de l'adapter au pompage disponible et, d'autre part, la cavité laser, par l'intermédiaire de la géométrie et de la transmission du miroir de sortie.

Une fois ces paramètres fixés, le système a un point de fonctionnement caractérisé par la durée des impulsions (« pulses ») émis, la fréquence de répétition, et la puissance émise, ainsi que l'énergie par impulsion (« pulse »).

Les monocristaux utilisés comme absorbant saturable (A. S.) doivent donc présenter des caractéristiques bien précises qui sont obtenues par un contrôle très précis des substitutions et de l'épaisseur du matériau.

Les microlasers, actuellement fabriqués, tels que les microlasers déclenchés passivement comprennent généralement un milieu ou matériau actif solide qui peut être constitué d'un matériau de base choisi, par exemple parmi Y₃Al₅O₁₂, LaMgAl₁₁O₉ (LMA), YVO₄, Y₂SiO₅, YLiF₄ et GdVO₄ dopés avec un élément tel que l'Erbium (Er), l'Ytterbium (Yb), le Néodyme (Nd), le Thulium (Tm), l'Holmium (Ho), ou codopés par un mélange de plusieurs de ces éléments, tels que Er et Yb, ou Tm et Ho.

Les microlasers fonctionnent à différentes longueurs d'ondes suivant leur substitution, ainsi leur longueur d'onde d'émission est autour de 1,06 µm, lorsque la matière active est dopée par Nd³⁺, autour de 1,55 µm, lorsqu'elle est dopée par Er³⁺, Yb³⁺, et autour de 2 µm, lorsqu'elle est dopée par Tm³⁺ et Ho³⁺.

Par ailleurs, des absorbants saturables connus contiennent des molécules organiques responsables de l'absorption. Ces matériaux, qui se présentent sous forme liquide ou plastique, sont très souvent de mauvaise qualité optique, vieillissent très vite et ont une mauvaise tenue au flux laser.

Des matériaux solides massifs sont aussi utilisés en tant qu'absorbants saturables. Par exemple pour les lasers émettant autour de 1 µm, dont la matière active est constituée de YAG avec des ions actifs Nd³⁺ ou Yb³⁺, on peut utiliser des cristaux de LiF : F₂ comportant des centres colorés responsables du comportement d'absorbant saturable du matériau et qui ont une durée de vie limitée, ou bien encore certains cristaux massifs dopés au Cr⁴⁺ qui présentent une absorption saturable autour de 1 µm.

Les absorbants saturables massifs présentent notamment l'inconvénient d'une concentration en ion absorbant limité, qui nécessite l'emploi d'une grande épaisseur de matériau.

Pour remédier aux problèmes posés par les absorbants saturables massifs, le document FR-A-2 712 743 décrit une cavité laser à milieu actif solide dans lequel l'absorbant saturable est réalisé sous la forme d'une couche mince monocristalline.

La forme de couche mince permet notamment de minimiser les pertes à l'intérieur de la cavité laser qui sont dues à la forme massive de l'absorbant saturable classique.

En outre, il est possible de déposer la couche mince sur des substrats de forme et de dimensions variées.

Enfin, la forme de couche mince permet également de réaliser un gain de place à l'intérieur de la cavité laser.

La couche mince est, dans ce document, réalisée de préférence par épitaxie en phase liquide. Une telle technique de dépôt permet notamment d'accéder à des concentrations en dopants plus élevées que les procédés classiques de croissance de cristaux massifs, c'est-à-dire les procédés tels que Czochralski, Bridgman...

Elle permet également d'élaborer plus facilement des couches monocristallines dopées par différents ions. Par ailleurs, l'épitaxie en phase liquide (EPL) est le seul procédé classique qui permette d'obtenir des couches monocristallines d'épaisseurs importantes supérieures, par exemple à 100 µm.

Dans ce document ainsi que dans le document EP-A-0 653 824, il est également décrit le dépôt par épitaxie en phase liquide de la couche mince d'absorbant saturable, directement sur le matériau actif laser jouant le rôle de substrat.

Pour cela, il faut que le matériau actif soit de même structure que le matériau absorbant saturable et que l'épitaxie en phase liquide de ce matériau soit réalisable.

A ce jour, il a été démontré que seul Y₃Al₅O₁₂ remplissait ces conditions.

De ce fait, en général, à l'heure actuelle, les microlasers déclenchés fonctionnent avec un absorbant saturable « rapporté » dans la cavité laser.

Il serait donc souhaitable de disposer d'autres matériaux remplissant ces conditions.

Il se trouve que parmi les matériaux cités ci-dessus, les matériaux de la famille du LaMgAl₁₁O₁₉ (LMA) présentent un grand intérêt.

En effet, le LMA dopé Nd³⁺ par exemple, offre un coefficient d'absorption et une section efficace faibles et ses bandes d'absorption et d'émission sont larges.

Ainsi, le LMA substitué par des ions de terres rares (TR³⁺) est-il intéressant comme source laser et amplificateur.

Le LMA substitué par des métaux de transition, tels que Co²⁺ peut également jouer le rôle d'absorbant saturable.

D'autre part, comme cela est mentionné dans le document FR-A-2 599 733, il existe une solution solide aluminium gallium qui permet de jouer sur une large gamme de substitution.

Les gallates mixtes de lanthanide-magnésium décrits dans ce dernier document, et obtenus notamment sous forme de monocristaux, peuvent, en particulier, être utilisés comme émetteurs lasers.

Or, il se trouve que la cristallogénèse du LMA est particulièrement délicate du fait de sa structure.

En effet, le LaMgAl₁₁O₁₉ cristallise dans le système hexagonal (groupe d'espèce P6₃/mmc) et le composé stoechiométrique ne présente pas de fusion congruente.

La composition chimique à fusion congruente correspond en fait à une composition légèrement déficitaire en lanthane et en magnésium à savoir La_{0.9}Mg_{0.5}Al_{11.433}0₁₉.

La substitution en certaines terres rares, telles que Nd³⁺ est aisée, sans problèmes chimiques de limitation de concentration.

Le LMA : Nd est un matériau utilisé dans certaines applications très spécifiques, comme les microlasers pour l'injection laser et la magnétométrie et les amplificateurs de lasers.

Le LMA : Co, comme on l'a indiqué plus haut, est également un absorbant saturable potentiel à 1,55 µm.

Pour de telles applications, on a vu que le matériau est utilisé sous forme de monocristaux convenablement conditionnés, de préférence, sous forme de couches minces monocristallines, ce qui permet par exemple d'optimiser les performances et de diminuer l'encombrement du laser.

Il serait intéressant, comme pour d'autres matériaux, de disposer de couches monocristallines, en particulier de couches minces de LMA, mais de telles couches n'ont, jusqu'à présent, jamais été réalisées.

Aucune technique de croissance, ne permet en effet leur fabrication.

Il existe donc un besoin, non encore satisfait, pour un procédé permettant de fabriquer des couches, en particulier des couches minces monocristallines, de matériaux de la famille du LaMgAl₁₁O₁₉.

L'invention a donc, entre autres, pour but de répondre à ce besoin.

L'invention a également pour but de remédier aux déficiences, inconvénients et limitations de l'art antérieur quant à la fabrication de telles couches

Ce but et d'autres encore sont atteints, conformément à l'invention, par un procédé de préparation d'une couche monocristalline d'aluminate de lanthane et de magnésium (LaMgAl₁₁O₁₉) (LMA), éventuellement dopé, sur un substrat, par croissance par épitaxie en phase liquide, à partir d'un bain d'épitaxie comprenant un soluté et un solvant, dans lequel ledit solvant est constitué d'un mélange de Bi₂O₃ et de B₂O₃, et la croissance épitaxiale est réalisée à température constante dans la gamme de 900 à 1 000°C.

Il est tout à fait surprenant, du fait, en particulier, des difficultés présentées par la cristallogénèse du LMA, que l'on ait pu préparer des couches telles que des couches minces monocristallines, de ce matériau par épitaxie en phase liquide.

L'art antérieur dissuadait, en effet, plutôt l'homme du métier de préparer des couches, telles que des couche minces, monocristallines, de LMA, par un procédé mettant en jeu une croissance cristalline.

De même le choix, parmi d'autres procédés de croissance, de l'épitaxie en phase liquide est également surprenant du fait de la difficulté que représente, en vue de la croissance épitaxiale d'un matériau particulier, le choix d'un bain d'épitaxie et des conditions expérimentales de la croissance épitaxiale.

En effet, la composition d'un bain d'épitaxie permettant la croissance d'un matériau particulier, définie notamment par le solvant mis en oeuvre, est totalement imprévisible, tout à fait spécifique du matériau en cause, et ne peut en aucune manière se déduire des compositions de bain d'épitaxie connues pour la croissance d'autres matériaux.

Il en est de même des conditions expérimentales de la croissance épitaxiale et, en particulier, de la température à laquelle est réalisée cette croissance épitaxiale.

Il a été mis en évidence, dans l'invention, que la croissance du LMA, est possible par épitaxie en phase liquide en choisissant un bain d'épitaxie spécifique, comprenant un solvant spécifique constitué d'un mélange de Bi₂O₃ et de B₂O₃.

Un tel solvant permet de préparer une phase a épitaxier extrêmement stable, au contraire d'autres solvants, par exemple à base de Pb, ou de Ba qui pourraient conduire à la formation de PbAl₁₂O₁₉ ou de BaAl₁₂O₁₉.

L'utilisation de B203 permet d'obtenir un bain liquide extrêmement peu visqueux, et possédant une zone de sursaturation grande.

Par ailleurs, les conditions de température spécifiques dans lesquelles la croissance épitaxiale est réalisée, c'est-à-dire à une température constante dans la gamme de 900 à 1 000°C, limitent la substitution des cations constituant le solvant dans le LMA à épitaxier.

La mise en oeuvre selon l'invention d'une température élevée limite, en particulier, que Bi³⁺ soit introduit en grande quantité dans le LMA à la place de La³⁺.

Toutefois, le composé BiMgAl₁₁O₁₉ existant , Bi³⁺ se substitue simplement à La³⁺ sans compensation de charges et sans provoquer un altération des propriétés laser.

Le procédé selon l'invention présente, en outre, tous les avantages inhérents au procédé de croissance par épitaxie en phase liquide (EPL), qui sont déjà, pour la plupart, mentionnés plus haut ou qui sont développés de manière plus approfondie dans les documents de l'art antérieur cités ci-dessus.

En particulier, il est possible, par ce procédé d'EPL, d'obtenir, des dopages homogènes, par exemple en terres rares, en métaux de transition, ou en gallium.

Ce paramètre d'homogénéité est un paramètre essentiel lorsque l'on veut optimiser les performances optiques d'un dispositif.

Dans la technique d'épitaxie en phase liquide, selon l'invention, les couches sont réalisées à température constante dans la gamme précitée et présentent, de ce fait, une bonne homogénéité de composition en volume.

Seuls l'interface et la surface de la couche peuvent être éventuellement perturbés, mais alors un léger polissage de la surface permet de s'affranchir de ce défaut.

De plus, l'épitaxie permet d'accéder à des concentrations en dopant beaucoup plus élevées que les procédés classiques de croissance de cristaux massifs, ce qui permet d'utiliser des couches de très faible épaisseur avec les avantages qui en découlent.

L'épitaxie en phase liquide offre, par ailleurs, la possibilité de réaliser des codopages par différents ions, en effet, il est souvent nécessaire d'utiliser plusieurs substitutions pour optimiser les propriétés de la couche épitaxiée, telles que le paramètre de maille, l'indice de réfraction, l'absorption etc...

Par la technique d'épitaxie en phase liquide, il est possible de préparer des couches de compositions complexes à plusieurs cations.

La technique d'épitaxie en phase liquide permet un contrôle aisé de l'épaisseur de la couche déposée, celle-ci a, généralement, une épaisseur de 1 à 500 µm, de préférence de 1 à 200 µm, de préférence encore de 20 à 150 µm, mieux de 50 à 100 µm.

On parlera de « couches minces » pour des épaisseurs généralement de 1 à 150 µm, de préférence de 1 à 100 µm.

la vitesse de croissance étant généralement de l'ordre de 1 µm/mn ; on peut relativement rapidement, c'est-à-dire en l'espace de quelques heures, préparer des couches ayant une épaisseur de 100 µm.

Par couche (mince) d'aluminate de lanthane et de magnésium (LMA), éventuellement dopé, on entend les couches composées, aussi bien de LMA stoechiométrique LaMgAl₁₁O₁₉, que de LMA voisin de la stoechiométrie, tel que déjà mentionné plus haut par exemple, légèrement déficitaire en lanthane et en magnésium et répondant, par exemple à la formule La_{0.9}Mg_{0.5}Al_{11.433}0₁₉.

Par LMA « dopé », on entend un LMA tel que défini ci-dessus, c'est-à-dire stoechiométrique ou non stoechiométrique (déficitaire en l'un ou plusieurs de ses éléments essentiels) ayant subi au moins une substitution.

Le substituant ou dopant, est par exemple, choisi parmi les terres rares, telles que le néodyme, le lutécium, l'yttrium et les métaux, tels que le cobalt, le chrome, le titane et le gallium.

Selon l'invention, il est possible de préparer des couches codopées, c'est-à-dire composées de LMA, comportant plusieurs substituants ou dopants choisis parmi les substituants ou dopants cités ci-dessus.

Un tel exemple de codopage est, par exemple le LMA dopé à la fois par Nd et Cr, ou par Nd et Ti.

La concentration du ou des dopant(s) peut varier entre de larges limites et peut aller jusqu'à 100 % en mole pour les terres rares, elle sera de préférence pour chacun des dopants de 0,1 à 10 % en mole, en particulier par exemple de 0,1 à 10 % en mole pour les terres rares et de 0,1 à 5 % en mole pour les métaux.

Pour préparer ces couches, les oxydes des différents constituants essentiels du LMA à savoir Al₂O₃, MgO, La₂O₃ sont mis en solution avec le solvant spécifique selon l'invention du bain d'épitaxie en phase liquide.

Les rapports molaires des différents oxydes sont ajustés autour de la valeur correspondant à la stoechiométrie.

La ou les différente(s) substitution(s) requise(s) sont éventuellement réalisées par ajout dans le bain de solutés du ou des oxyde(s) des éléments substituants, dopant(s) mentionnés plus haut, le solvant demeurant, bien entendu, le même.

Pour chaque composition de couche visée, il correspond un bain d'épitaxie différent par la nature du soluté mis en oeuvre.

Le substrat peut être tout substrat sur lequel peut être déposé une couche telle qu'une couche mince, de LMA, éventuellement dopé, par la technique d'épitaxie en phase liquide.

Toutefois, le substrat est généralement constitué d'un matériau de base identique au matériau de base déposé, c'est-à-dire le LMA, ou de structure cristalline identique ou proche de celle du matériau de base déposé.

Il est donc souvent nécessaire d'ajuster les paramètres de maille du substrat et de la couche : paramètre « a » dans le cas d'une croissance (100) tout en conservant des paramètres « c » pas trop éloignés. Cet ajustement se fait à l'aide des dopants adéquates décrits plus loins, ajoutés éventuellement dans le bain d'épitaxie sous la forme d'oxyde(s). Autrement dit, le substrat et la couche sont de même structure cristalline et ne se différencient que par les différents dopants qui affectent par exemple les propriétés cristallines et/ou optiques de la couche et/ou du substrat, de préférence de la couche.

Ainsi, le substrat peut être du LMA dopé ou non suivant l'application visée. Lorsque le substrat est dopé le ou les dopants(s) sont analogues à ceux cités ci-dessus et plus bas pour les couches monocristallines. De préférence, le substrat est constitué de LMA non dopé (non actif).

Le LMA peut être un LMA stoechiométrique de formule LaMgAl₁₁O₁₉ ou un LMA voisin de la stoechiométrie déjà cité plus haut. Les substrats généralement préparés à partir de cristaux obtenus par tirage Czochralski orientés (100).

L'invention a également trait à une couche monocristalline d'aluminate de Lanthane et de magnésium (LMA), éventuellement dopé, susceptible d'être obtenu par croissance par épitaxie en phase liquide.

La structure spécifique de la couche selon l'invention qui consiste en une couche monocristalline permet de garder la faisabilité d'un dispositif compact et d'une éventuelle fabrication collective à bas coût. Cette structure ne remet pas en cause les propriétés du matériau, mais au contraire permet de les améliorer par utilisation des phénomènes d'ondes guidées dans certains cas.

De même, les couches selon l'invention présentent aussi tous les avantages liés à la technique de croissance utilisée, l'épitaxie en phase liquide et qui ont déjà été indiqués plus haut.

Cette couche présente généralement l'épaisseur déjà indiquée plus haut.

Le LMA est choisi, de même, parmi le LMA stoechiométrique et les LMA voisins de la stoechiométrie.

Le LMA stoechiométrique ou non peut être dopé par exemple par au moins un dopant choisi parmi les terres rares telles que le néodyme, le lutécium, l'yttrium, et les métaux tels que le cobalt, le chrome, le titane et le gallium.

Le type, la nature, le nombre, la proportion du ou des dopants sont variables et dépendent de l'application désirée.

Dans le cas où la couche, en particulier la couche mince, est destinée à jouer le rôle de matériau actif laser, le LMA est dopé par un ou plusieurs ions lui conférant des propriétés de matériau actif laser.

La plupart des ions utilisés pour conférer du LMA des propriétés de matériau actif laser peuvent être aussi utilisés pour rendre le LMA amplificateur.

Ainsi le LMA (stoechiométrique ou non) peut être dopé avec des ions actifs Nd (néodyme) ou Cr (chrome) pour une émission autour de 1,06 µm, avec des ions actifs Er (erbium) ou Ytterbium pour une émission autour de 1,5 µm, avec des ions actifs Ho (Holmium) ou Tm (thullium) pour une émission à 2 µm, le LMA peut également être codopé par des ions Er et Yb (Erbium-Ytterbium) pour une émission à 1,5µm, par des ions Tm et Ho (thullium et Holmium) pour une émission à 2 µm, ou par des ions Er, Yb et Ce (Erbium, Ytterbium et Cérium) pour une émission à 1,5 µm.

La proportion du ou des dopant(s) est généralement (en mole) de 0,1 à 10 %.

Par rapport au dopage à l'Erbium seul, le codopage à l'Erbium et à l'Ytterbium permet d'absorber plus d'énergie de pompage.

Le LMA stoechiométrique ou non peut également être dopé par un ou plusieurs ions lui conférant des propriétés d'absorbant saturable.

Ainsi le LMA peut-il être dopé par des ions Chrome (Cr), Ytterbium (Yb), Erbium ou Thulium.

De préférence, le LMA est dopé par des ions cobalt. Le LMA est généralement dopé au cobalt dans une proportion supérieure à 0,1% et inférieure à 1 % par exemple 0,15 ; 0,13 ; ou 0,4 %. Un dopage à 0,3 % (en mole) en ions cobalt Co²⁺ a été réalisé dans du LMA sous stoechiométrique de formule La_{0,9}Mg_{0,5}Al_{11,433}O₁₉, le matériau dopé a la formule La_{0,9}Mg_{0,4985}Co_{0,0015} Al_{11,433}O₁₉. La formule générale du LMA sous stoechiométrique dopé au cobalt est La_{0,9}Mg_{0,2-x}CoₓAl_{11,433}O₁₉.

Si l'on effectue un dopage au cobalt du LMA stoechiométrique de formule LaMgAl₁₁O₁₉, on obtient après dopage un composé de formule LaMg₁₋ₓCoₓAl₁₁O₁₉.

Dans ce contexte, le LMA présente l'avantage de contenir des ions Mg²⁺ que l'on peut substituer avec des ions cobalt sans compensation de charges.

Les couches selon l'invention dopés ou non peuvent également comprendre (en outre) au moins un autre dopant ou substituant afin d'en modifier l'une ou l'autre des propriétés par exemple structurales et/ou optiques telles que l'absorption, l'indice de réfraction et/ou le paramètre de maille.

Ces dopants sont choisis par exemple parmi le gallium et les terres rares non actives, telles que le lutécium, le gadolinium, l'yttrium, par terres rares, non actives on entend généralement des terres rares qui au contraire des terres rares citées plus haut, ne communiquent pas des propriétés telles que des propriétés d'émetteur laser, d'amplificateur ou d'AS au LMA.

On pourra ainsi en outre réaliser un codopage des couches avec du Gallium (Ga) et/ou une terre rare non active telle que l'yttrium (Y), et/ou le lutécium (Lu) et/ou le gadolinium.

Un codopage supplémentaire préféré est un codopage Gallium-Lutécium, dans lequel le gallium sert à adapter l'indice, le gallium élargissant par ailleurs la maille du réseau cristallin, cet élargissement est compensé par du Lutécium.

L'invention est également relative à un empilement multicouche comprenant, éventuellement sur un substrat, une succession de une ou plusieurs couches selon l'invention.

Le nombre de ces couches est variable et peut aller de 1 (si un substrat est présent) jusqu'à 10, de préférence ce nombre est de 1 à 5 de préférence de 1 à 3, par exemple 2. Le substrat est de préférence un LMA stoechiométrique ou non et/ou dopé ou non tel que défini plus haut.

Les empilements selon l'invention incluent toutes les combinaisons possibles de couches quant à leur nature, leur composition, leur nombre et leur succession.

L'invention concerne également un composant optique comportant au moins une couche monocristalline d'aluminate de Lanthane et de magnésium, éventuellement dopé telle qu'elle est décrite ci-dessus.

L'invention a trait en outre à un composant optique comportant au moins un des empilements décrits plus haut.

A titre d'exemple de composants optiques, on peut citer, les sources lasers, les absorbants saturables, les amplificateurs et les doubleurs de fréquence. L'invention a également trait aux cavités lasers en particulier pour microlasers, aux cavités lasers présentant une structure de guide d'onde, aux amplificateurs guide d'onde etc... aux cavités lasers à absorbants saturables incluant de tels composants.

L'invention concerne donc également une cavité laser en particulier pour microlaser caractérisée en ce qu'elle comprend un milieu actif solide et une couche mince d'absorbant saturable selon l'invention épitaxiée directement sur le milieu actif solide.

Ce milieu actif solide (substrat) est de préférence du LMA dopé comme indiqué ci-dessus par un ou plusieurs ions lui communiquant des propriétés de matériau actif laser.

L'invention concerne également une cavité laser en particulier pour laser guide d'onde ou amplificateur guide d'onde comprenant un substrat de LMA non dopé, une couche mince monocristalline de LMA dopé selon l'invention épitaxiée sur ce substrat, et une couche mince de LMA non dopé selon l'invention épitaxiée sur cette couche mince de LMA dopé.

L' invention concerne enfin une cavité laser comprenant une couche mince d'absorbant saturable selon l'invention épitaxiée sur un substrat de LMA non dopé, rapportée à l'intérieur de la cavité, le matériau actif laser émettant à une longueur d'onde correspondant à l'absorption du matériau épitaxiée (de l'absorbant saturable).

Le matériau actif est par exemple constitué d'un verre erbium/ytterbium émettant à 1,55 µm et la couche mince d'absorbant saturable est alors constituée de LMA dopé Co²⁺.

Les caractéristiques et avantages de l'invention apparaîtront mieux à la lecture de la description qui va suivre, donnée à titre purement illustratif et non limitatif, en faisant référence aux dessins joints dans lesquels :
- la figure 1 est une représentation schématique d'un laser guide d'onde comprenant une couche active épitaxiée de LMA dopé selon l'invention;
- la figure 2 est une représentation schématique d'un amplificateur guide d'onde selon l'invention comprenant une couche active épitaxiée de LMA dopé selon l'invention;
- la figure 3 est une représentation schématique d'une cavité laser selon l'invention comportant un absorbant saturable formé d'une couche de LMA dopé épitaxiée, rapporté.

Ainsi, de manière plus précise, le procédé de l'invention comprend tout d'abord, de manière générale, une première étape de choix et de préparation du substrat.

Comme mentionné plus haut, le substrat peut être tout substrat sur lequel peut être déposé une couche mince de LMA, éventuellement dopé, par la technique d'épitaxie en phase liquide.

Ces substrats ont déjà été pour la plupart décrits ci-dessus.

Dans le cas d'une application dans le domaine du laser, le type de laser à réaliser détermine l'ion ou les ions dopant(s) de la couche de LMA déposé, ainsi que le type de LMA utilisé pour le substrat.

Le mode de fonctionnement de ce laser détermine si le substrat doit être constitué d'un matériau actif laser ou non, ainsi que sa forme et ses dimensions.

La dimension et la forme du substrat sont variables, l'un des avantages de la technique d'épitaxie en phase liquide est précisément qu'elle permet de réaliser des couches d'excellente qualité, quelle que soit la forme, même complexe, et la taille du substrat.

Le substrat peut, par exemple, être préparé à partir d'un lingot de LMA dopé ou non, d'un diamètre, par exemple, de 1'' à 2'' (inches), c'est-à-dire environ 25 à 50 mm, orienté (100).

On découpe à partir de ce lingot des substrats, par exemple en forme de lames à faces parallèles à l'aide d'un instrument de coupe adéquate, par exemple à l'aide d'une scie à lame diamantée.

On procède ensuite au rodage et au polissage d'au moins une des faces du substrat. Le rodage a pour rôle :
- d'une part, d'enlever la couche d'écrouissage superficielle due à la découpe ;
- d'autre part, éventuellement, de ramener l'épaisseur des lames à l'épaisseur voulue, par exemple dans le cas d'une application laser, cette épaisseur est légèrement supérieure à la spécification du microlaser et est généralement de 100 à 1000 µm.

En effet, l'épaisseur du milieu actif est un paramètre qui conditionne certaines caractéristiques du microlaser, telles que la largeur du spectre et le nombre de modes longitudinaux, notamment.

Les substrats, par exemple les lames rodées et, éventuellement, rapprochées de l'épaisseur voulue, sont ensuite polis avec une qualité optique.

Le polissage concerne au moins une des faces du substrat, mais pour certains types de fonctionnement, par exemple pour un laser guide d'ondes, le substrat peut présenter deux faces parallèles ayant cette qualité de poli. On parle ainsi de substrat à une face polie, ou à deux faces polies.

Le polissage est réalisé par un procédé mécanochimique afin que la ou les faces polie(s) soi(ent) exempte(s) de tout défaut (inclusion, dislocation, contrainte, rayure, etc.) qui se propagerait dans l'épaisseur de la couche lors de l'épitaxie. Cette qualité de polissage est contrôlée par une attaque chimique appropriée. Le procédé à mettre en oeuvre est sensiblement identique à celui mis au point pour les substrats utilisés dans les techniques classiques d'épitaxie.

Des méplats orientés, par exemple deux méplats orientés (001) et (010), peuvent être marqués sur les bords de chaque lame.

Suite à la première étape, de choix et de préparation du substrat, on procède ensuite dans une deuxième étape à la préparation du bain d'épitaxie qui est une solution sursaturée formée d'un solvant et d'un soluté.

Selon l'invention, le bain d'épitaxie est préparé, tout d'abord, en pesant soigneusement un mélange des oxydes Bi₂O₃ - B₂O₃ - le mélange de ces deux oxydes formant le solvant - La₂O₃, MgO et Al₂O₃ qui forment le soluté.

Le ou les différent(s) dopant(s) est(sont) également, éventuellement, ajouté(s) sous forme d'oxyde(s), par exemple Nd₂O₃, Ga₂O₃, il est également parfois nécessaire, pour réaliser la compensation de charges éventuelle, d'ajouter un ou plusieurs autres oxydes tels que les oxydes des éléments cités plus haut.

La concentration en moles % des différents oxydes dans le bain d'épitaxie pour la préparation de LMA non dopé est en mole %, par exemple, de 0,5 à 1 mole % de La₂O₃, de 1 à 1,5 mole % de MgO, de 0,5 à 1,5 mole % de Al₂O₃, de 90 à 95 mole % de Bi₂O₃, et de 5 à 10 mole mole % de B₂O₃.

Le ou les oxydes du ou des dopant(s) lorsqu'il(s) est(sont) présent(s) est(sont) dans les proportions indiquées ci-dessus pour chacun d'entre eux.

Un mélange typique est, à titre d'exemple, constitué de 6,4 g de La₃O₃, 1,2 g de Nd₂O₃, 1 g de MgO, 27 g de Al₂O₃, 810 g de Bi₂O₃ et 9 g de B₂O₃.

Le mélange soluté, solvant est ensuite fondu dans un dispositif adéquat, par exemple dans un creuset en platine à une température, par exemple, de 900 à 1100 °C, par exemple d'environ 1000°C pour former le bain d'épitaxie proprement dit. Le dispositif, tel qu'un creuset, est ensuite placé dans un dispositif classique permettant de réaliser une croissance cristalline par épitaxie en phase liquide.

Ce dispositif est, par exemple, un four d'épitaxie qui est, en particulier, un four à deux zones de chauffe, à gradient de température contrôlé.

De préférence, le substrat est animé d'un mouvement de rotation ou de translation uniforme, ou alterné permettant un dépôt d'une épaisseur homogène.

De même, le bain d'épitaxie peut être agité mécaniquement à l'aide d'un dispositif adéquat, tel qu'un agitateur en platine.

Une broche supportant l'agitateur, ou l'ensemble porte substrat-substrat permet de communiquer les mouvements voulus à l'un ou l'autre.

La troisième étape du procédé est l'étape d'épitaxie proprement dite.

Selon l'invention, l'opération d'épitaxie en phase liquide est réalisée à une température constante dans la plage de 900°C à 1 000°C, ce qui permet d'obtenir une concentration en dopant homogène dans l'épaisseur de la couche.

On commence, par exemple, à agiter mécaniquement le mélange liquide à une température légèrement supérieure à la température de croissance épitaxiale, par exemple, à environ 1 050°C à l'aide du dispositif d'agitation déjà décrit plus haut, tel qu'un agitateur en platine. On abaisse ensuite la température du four jusqu'à la température de trempe qui est, de préférence, encore de 950 à 980°C.

Le substrat, par exemple positionné horizontalement est ensuite mis en contact avec le bain d'épitaxie, les substrats à une face polie sont trempés en surface du bain alors que les substrats à deux faces polies sont immergés dans ce bain.

La durée de la mise en contact dépend de l'épaisseur désirée, cette épaisseur pouvant varier dans les plages déjà citées plus haut, c'est-à-dire de 1 à 500 µm, par exemple 100 µm. Les vitesses de croissance sont généralement de l'ordre de 0,5 à 1 µm/mn et la durée de la mise en contact sera donc généralement de 10' à 10 h.

A la sortie du bain d'épitaxie, le substrat et la (pour un substrat à une face) ou les couche(s) épixtaxiée(s) (pour un substrat à deux faces, avec une couche épitaxiée sur chaque face) subissent une opération destinée à éliminer le solvant. Par exemple, le substrat revêtu est soumis à un mouvement de rotation accélérée pour éjecter les restes de solvant.

Un nettoyage chimique, au moyen par exemple d'un acide tel que HNO₃ termine l'étape d'épitaxie.

Lorsque cela est nécessaire, dans le cas de certaines applications, par exemple pour un laser guide d'onde, on peut réaliser des épitaxies successives de LMA dopés différemment ou non dopés, afin de créer un empilement de couches, par exemple de 2 à 5 couches, de préférence trois couches présentant la même structure cristalline, mais ayant des propriétés optiques différentes.

Le fait de pouvoir réaliser des empilements multicouches est l'un des avantages présenté par le procédé de dépôt mis en oeuvre dans l'invention, à savoir l'épitaxie en phase liquide.

On réalise éventuellement, après le dépôt de chaque couche, c'est-à-dire entre deux épitaxies successives, et à la fin du procédé un repolissage de la couche (ou des couches) déposées, ce repolissage a pour but d'enlever une éventuelle rugosité provoquée par le dépôt et d'amener l'épaisseur de la ou des couche(s) déposée(s) à la valeur voulue correspondant à l'application souhaitée. Il est même possible d'éliminer l'une des deux couches déposées (substrat à deux faces).

Ce repolissage ou ajustement en épaisseur est généralement réalisé par attaque chimique par exemple dans l'acide phosphorique ou par polissage mécanochimique.

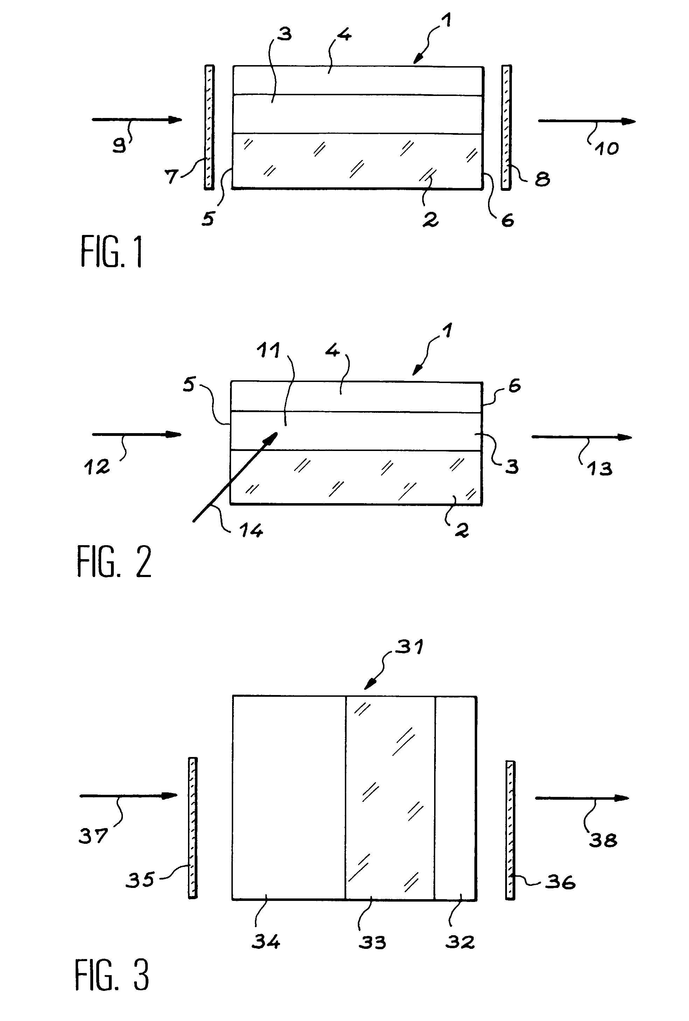

Des modes de réalisation de l'invention, dans lesquels les couches épitaxiées de LMA, selon l'invention, sont mises en oeuvre, sont représentés aux figures 1 à 3.

La figure 1 représente un laser guide d'onde, dans lequel la cavité laser (1) comprend un substrat de LMA non actif (2), sur lequel est déposé par le procédé de l'invention une couche active de LMA (3) sur laquelle est déposée, par le procédé de l'invention, une couche de LMA non dopé (4).

Plus précisément, sur un substrat de LaMgAl₁₁O₁₉ (LMA) non dopé (2), obtenu par découpe et polissage d'un monocristal, est épitaxiée une couche de LaMgAl₁₁O₁₉ dopé par une terre rare active (3) (par exemple du néodyme en une concentration pouvant aller de 0 à 100 %, de préférence de 1 à 20 %).

L'épaisseur de la couche épitaxiée peut varier de quelques microns à quelques dizaines de microns, c'est-à-dire de 5 à 100 µm.

Le paramètre de maille de la couche et son indice de réfraction sont ajustées par une ou plusieurs substitutions, telles que le gallium à la place de l'aluminium et(ou) une terre rare non active, telle que l'yttrium, ou le lutécium, etc. à la place du lanthane.

Afin de réaliser un guide d'onde performant et symétrique, une couche de LaMgAl₁₁O₁₉ non dopé (4), ayant une épaisseur de quelques dizaines de microns, par exemple de 20 à 50 µm et un indice de réfraction inférieur à celui de la couche dopée (3), est épitaxiée directement sur la couche active (3).

La couche est ensuite découpée en échantillons de quelques millimètres de côté ayant deux faces parallèles polies afin de réaliser les faces entrée/sortie (5,6) du guide d'onde laser. La cavité laser est réalisée en plaçant sur ces deux faces des miroirs diélectriques d'entrée et de sortie (7,8) rapportés ou déposés directement. La distance entre les deux faces constitue la longueur de la cavité et dépend de l'absorption du matériau. Généralement, le guide est pompé à l'aide d'une diode laser émettant à la longueur d'onde d'absorption du matériau.
La flèche (9) représente le pompage diode tandis que le flèche (10) représente l'émission laser continue à la sortie du guide.

La figure 2 décrit un amplificateur guide d'onde dont le principe de séparation est sensiblement le même que celui du guide d'onde décrit sur la figure 1.

Les références (1 à 6) de la figure 2 sont donc les mêmes que celles de la figure 1.

Mais, dans cette application, une troisième face (11) du guide, perpendiculaire aux deux premières (plan de la feuille) est également polie. Cette face servira de face de pompage. Dans le cas d'un amplificateur, le pompage peut être réalisé par une barrette de diodes. Le pompage diode est représenté par la flèche 14. Un faisceau laser émettant à une longueur d'onde identique à celle du matériau actif du guide est introduit (flèche 12) puis amplifié (flèche 13) par le pompage (14) à l'intérieur du guide.

La figure 3 décrit une cavité laser (31) comprenant un absorbant saturable (AS) sous la forme d'une couche active de LMA dopée (32) épitaxiée par le procédé selon l'invention.

Dans le cas d'une utilisation comme absorbant saturable (AS), la couche épitaxiée est placée transversalement à un faisceau laser. La couche épitaxiée est rapportée à l'intérieur d'une cavité laser (31) émettant à une longueur d'onde correspondante à l'absorption du matériau épitaxie. Dans ce cas, le laser subit un déclenchement passif permettant de réaliser un laser pulsé. L'AS est constitué d'une couche de LaMgAl₁₁O₁₉ dopé épitaxiée (32) sur un substrat (33) de LaMgAl₁₁O₁₉ non dopé. L'émetteur laser (34) peut être constitué d'un matériau massif actif tel qu'un verre erbium/ytterbium émettant à 1.55 µm. Dans ce cas, la couche jouant le rôle d'absorbant saturable est constituée de LaMgAl₁₁O₁₉ dopé Co²⁺. L'épaisseur de la couche et la concentration en cobalt sont ajustées en fonction des propriétés désirées du laser.

La cavité laser comprend en outre des miroirs d'entrée et de sortie (35,36). Le pompage diode est représenté par la flèche (37) tandis que l'émission laser pulsée (« Q-switchée ») est représentée par la flèche (38).

## Revendications

1. Couche monocristalline d'aluminate de lanthane et de magnésium (LMA), éventuellement dopé, susceptible d'être obtenue par croissance par épitaxie en phase liquide.

2. Couche selon la revendication 1 caractérisé en ce qu'elle a une épaisseur de 1 à 500 µm.

3. Couche selon la revendication 2 caractérisée en ce qu'elle a une épaisseur de 1 à 150 µm.

4. Couche selon l'une quelconque des revendications 1 à 3 caractérisée en ce que l'aluminate de lanthane et de magnésium est choisi parmi le LMA stoechiométrique de formule LaMgAl₁₁O₁₉ et les LMA voisins de la stoechiométrie tels que le LMA de formule La_{0,9}Mg_{0,5}Al_{11,433}O₁₉.

5. Couche selon l'une quelconque des revendications 1 à 3 caractérisée en ce que l'aluminate de lanthane et de magnésium est dopé par au moins un dopant choisi parmi les terres rares, et les métaux, tels que le cobalt, le chrome, le titane et le gallium.

6. Couche selon la revendication 5 caractérisée en ce qu'elle joue le rôle de matériau actif laser ou d'amplificateur, le LMA étant dopé par un ou plusieurs ions lui conférant des propriétés de matériau actif laser ou d'amplificateur.

7. Couche selon la revendication 5 caractérisée en ce qu'elle joue le rôle d'absorbant saturable, le LMA étant dopé par un ou plusieurs ions lui conférant des propriétés d'absorbant saturable.

8. Couche selon la revendication 6 caractérisée en ce que le LMA est dopé par un ion actif choisi parmi Nd, Er, Yb, Cr, Ho et Tm, ou codopé par des ions actifs Er et Yb, ou Er, Yb et Ce ou Tm et Ho.

9. Couche selon la revendication 7 caractérisé en ce que le LMA est dopé par un ion choisi parmi Co, Er, Cr, Yb, et Tm.

10. Couche selon l'une quelconque des revendications 6 à 9 caractérisée en ce que le LMA est (en outre) dopé par au moins un (autre) dopant ou substituant permettant de modifier ses propriétés structurales et/ou optiques.

11. Couche selon la revendication 10 caractérisé en ce que ledit (autre) dopant est choisi parmi le gallium et les terres rares non actives.

12. Empilement multicouche caractérisé en ce qu'il comprend éventuellement sur un substrat, une succession d'une ou de plusieurs couches selon l'une quelconque des revendications 1 à 11.

13. Empilement selon la revendication 12 caractérisé en ce qu'il comprend jusqu'à 10 couches.

14. Empilement selon l'une quelconque des revendications 12 et 13 caractérisé en ce que le substrat est choisi parmi le LMA stoechiométrique, les LMA voisins de la stoechiométrie et les aluminates de lanthane et de magnésium dopés.

15. Composant optique caractérisé en ce qu'il comporte au moins une couche monocristalline d'aluminate de lanthane et de magnésium, éventuellement dopé, selon l'une quelconque des revendications 1 à 11.

16. Composant optique caractérisé en ce qu'il comporte au moins un empilement selon l'une quelconque des revendications 12 à 14.

17. Composant optique selon l'une quelconque des revendications 15 et 16 caractérisé en ce qu'il s'agit d'une source laser, d'un absorbant saturable, d'un amplificateur ou d'un doubleur de fréquence.

18. Cavité laser caractérisée en ce qu'elle comprend un milieu actif solide et une couche mince d'absorbant saturable selon l'une quelconque des revendications 7 et 9 epitaxiée directement sur le milieu actif solide.

19. Cavité laser selon la revendication 18 caractérisée en ce que ledit milieu actif solide est du LMA dopé par un ou plusieurs ions lui conférant des propriétés de matériau actif laser.

20. Laser guide d'onde ou amplificateur guide d'onde caractérisé en ce qu'il comprend une cavité laser comprenant un substrat de LMA non dopé, une couche mince monocristalline de LMA dopée selon l'une quelconque des revendications 6 et 8 épitaxiée sur ledit substrat, et une couche mince de LMA non dopé épitaxiée sur ladite couche mince de LMA dopé.

21. Cavité laser caractérisée en ce qu'elle comprend une couche mince d'aborbant saturable selon l'une quelconque des revendications 7 et 9 épitaxiée sur un substrat de LMA non dopé, rapportée à l'intérieur de la cavité, le matériau actif laser émettant à une largeur d'onde correspondant à l'absorption de l'absorbant saturable.

22. Cavité laser selon la revendication 21 caractérisé en ce que le matériau actif laser est du verre, erbium/ytterbium émettant à 1,55 µm et la couche mince d'absorbant saturable est constituée de LMA dopé au cobalt.

23. Procédé de préparation d'une couche monocristalline d'aluminate de lanthane et de magnésium
